# FASCICULE DE BREVET EUROPEEN

(11) **EP 2 259 336 B1**
(45) Date de publication et mention de la délivrance du brevet: **01.04.2020**
(21) Numéro de dépôt: 10305595.0
(22) Date de dépôt: 04.06.2010
(51) Int. Cl.: H01L 31/048, H01L 31/042, H01L 31/05

(54) **ELÉMENT DE STRUCTURE POUR PANNEAU SOLAIRE, ET STRUCTURE COMPORTANT UN TEL ÉLÉMENT**
STRUKTURELEMENT FÜR SOLARPANEL UND STRUKTUR MIT EINEM SOLCHEN ELEMENT
STRUCTURE ELEMENT FOR SOLAR PANEL, AND STRUCTURE COMPRISING SUCH AN ELEMENT

(30) Priorité: 05.06.2009 FR 0953717
(43) Date de publication de la demande: 08.12.2010
(73) Titulaire: CENTRE NATIONAL D'ETUDES SPATIALES, 75001 Paris (FR)
(72) Inventeur: Payan, Denis, 31320, MERVILLA (FR)
(74) Mandataire: Delorme, Nicolas

(56) Documents cités:
- DE-A1- 4 303 055
- US-A- 4 433 201
- US-A- 4 534 998
- US-A1- 2005 278 936

## Description

La présente invention concerne une structure pour panneau solaire, du type comprenant au moins une couche de matériau diélectrique.

Les panneaux solaires comportent usuellement une partie structurelle conductrice destinée à recevoir un réseau de cellules solaires. La partie structurelle conductrice est recouverte d'au moins une couche de matériau diélectrique. On prévoit également des moyens d'adhésion entre la partie structurelle conductrice et ledit matériau diélectrique.

On connaît une telle structure de panneau solaire où la structure conductrice est usuellement réalisée sous la forme d'une structure en nid d'abeille réalisée en aluminium collée entre deux peaux constituées de fibres de carbone. Cette structure conductrice est reliée à la masse du satellite afin d'assurer l'équipotentialité, les cellules solaires étant fixées sur la couche de matériau diélectrique.

Pour assurer sa fonction structurelle, la structure en nid d'abeille est renforcée sur ses deux faces par des fibres de carbone noyées dans une colle structurelle de type époxy.

La couche de matériau diélectrique couramment utilisée est réalisée dans un polymère de polyimide, et elle est usuellement commercialisée sous le nom de Kapton® ou Upilex®.

La couche de matériau diélectrique est fixée sur la structure conductrice. Elle est donc en contact avec la colle époxy servant de liant aux fibres de carbone recouvrant la feuille, colle qui n'a pas de propriété conductrice particulière.

Les cellules photoélectriques sont fixées sous forme de matrice sur la couche de matériau diélectrique de la structure ainsi réalisée, formant ainsi une structure pour panneau solaire.

Quand une telle structure est mise en œuvre dans l'espace, il arrive que les couches de matériau diélectrique accumulent des charges.

De telles charges peuvent s'avérer dangereuses pour le fonctionnement du panneau solaire, car elles engendrent des décharges électrostatiques au niveau des couches de diélectrique ou des métallisations voisines, ce qui peut être à l'origine de dégradations considérables sur le panneau solaire.

Dans un mode de fonctionnement courant, on a pu constater que les charges accumulées étaient partiellement évacuées naturellement dans l'espace, par photo émission lorsque le panneau est éclairé. Elles sont également partiellement évacuées en migrant à travers la colle époxy servant à fixer la couche de Kapton® sur les fibres de carbone et/ou à noyer les fibres de carbone de la structure du panneau, comme il est décrit notamment dans le document US 4 534 998.

Les charges rejoignent ainsi naturellement la structure conductrice ayant pour fonction d'assurer une équipotentialité.

La colle époxy, qui avait pour simple fonction initiale d'assurer la liaison de la couche de matériau diélectrique au plan de fibres de carbone, et/ou de maintenir sur la feuille métallique des éléments de renfort, s'est donc vu attribuer une fonction supplémentaire d'évacuation des charges s'accumulant sur la couche de matériau diélectrique.

On a toutefois pu constater que la colle époxy n'assure plus cette fonction dans des conditions particulières, notamment quand le panneau solaire se trouve dans des positions d'éclipse de soleil, car elle devient très froide et par conséquent isolante électriquement.

En particulier, quand le panneau solaire est fixé sur un satellite mis en orbite géostationnaire (orbite GEO) autour de la terre, il se trouve totalement ou partiellement privé de la lumière du soleil au moment des équinoxes de printemps ou d'automne.

Il a été calculé que la durée totale de cette privation de lumière du panneau solaire, est d'environ 1 heure par jour pendant 22 jours de l'année.

Dans de telles conditions de privation de lumière, la température peut atteindre -180 °C.

C'est durant ces courtes périodes en sortie d'éclipse que les panneaux solaires subissent de nombreuses dégradations.

Par ailleurs, on a pu constater le même phénomène d'accumulation de charges sur les verres de protection des cellules photoélectriques des panneaux solaires.

Lorsque les panneaux solaires captent de la lumière, les charges accumulées sur les verres sont évacuées dans l'espace par photoémission ou au moins partiellement par conduction à travers la colle de silicone qui maintient le verre sur la cellule.

Toutefois, dans des situations d'éclipse de soleil, les charges accumulées sur le verre ne sont plus suffisamment évacuées et peuvent également être à l'origine de dégradations du panneau solaire, car la colle devient isolante à une température inférieure à 30 °C.

On connait par ailleurs US 4 433 201 décrivant une structure pour panneau solaire, comprenant une couche de matériau diélectrique, des moyens conducteurs et un moyen de connexion électrique pour relier les moyens conducteurs à la masse de ladite structure.

L'invention vise à pallier les inconvénients des colles époxy ou silicone dans de telles situations, en assurant la fonction d'évacuation des charges qui s'accumulent sur une couche de matériau diélectrique, qu'elle soit constituée d'une couche de Kapton® ou d'une plaque de verre protectrice, même à de très basses températures.

A cet effet, l'invention concerne une structure pour panneau solaire conforme à la revendication 1.

Un élément de structure comprise dans cette structure assure l'évacuation des charges accumulées dans ladite couche de matériau diélectrique, que cette couche soit par exemple une couche de polymère de polyimide ou une plaque de verre protectrice de cellule photoélectrique, et ce dans n'importe quelles conditions de température. En effet, d'une part les moyens conducteurs sont en contact avec la couche de matériau diélectrique et, d'autre part, il existe une différence de potentiel entre la couche de matériau diélectrique chargée et la masse de la structure.

Suivant des modes de réalisations qui seront décrits et illustrés par la suite, la structure selon l'invention peut comporter les caractéristiques additionnelles des revendications 2 à 7.

L'invention concerne enfin un panneau solaire comprenant une structure telle que définie ci-dessus.

L'invention sera d'avantage comprise à la lecture des exemples de réalisations qui vont maintenant être présentés en faisant référence aux figures annexées parmi lesquelles :
- la figure 1 est une vue en coupe d'un premier élément de structure faisant partie d'une structure de panneau solaire conforme à l'invention,
- la figure 2 est une vue de dessous de l'élément de structure montré en figure 1,
- la figure 3 est une vue en coupe d'un second élément de structure faisant partie d'une structure de panneau solaire conforme à l'invention,
- la figure 4 est une vue en coupe partielle d'une première structure pour panneau solaire conforme à l'invention,
- la figure 5 est une vue en coupe d'un troisième élément de structure faisant partie d'une structure de panneau solaire conforme à l'invention,
- les figures 6A et 6B montrent une première cellule photoélectrique comprenant un élément de structure conforme à l'invention, vue en coupe et de dessus,
- la figure 7 est une vue en coupe d'une seconde cellule comprenant un élément de structure conforme à l'invention,
- les figures 8A et 8B montrent une troisième cellule comprenant un élément de structure conforme à l'invention, vue en coupe et de dessus,
- la figure 9 est une vue en perspective éclatée d'une quatrième cellule comprenant un élément de structure conforme à l'invention, et
- la figure 10 est une vue en coupe partielle d'une seconde structure pour panneau solaire conforme à l'invention.

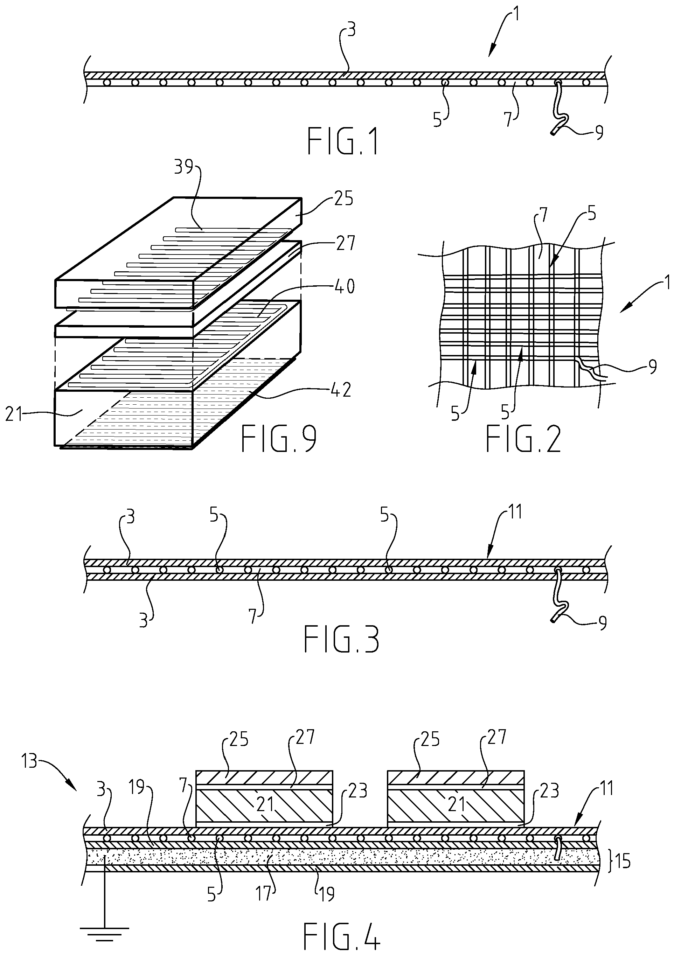

On s'intéressera dans un premier temps aux figures 1 à 5 et 9 qui montrent différents exemples de réalisation d'éléments de structures faisant partie de structures de panneau solaire conformes à l'invention qui sont destinés à supporter des cellules photoélectriques.

Dans un second temps, seront décrits des éléments conformes à l'invention destinés à la protection des cellules photoélectriques.

Les figures 1 et 2 montrent un premier élément 1 de structure pour panneau solaire comportant au moins une couche de matériau diélectrique 3.

La couche de matériau diélectrique 3 peut être un polymère de polyimide tel que celui commercialisé sous le nom de Kapton® ou Upilex®.

L'épaisseur de la couche de matériau diélectrique 3 peut être comprise entre 25 µm et 500 µm.

Conformément à l'invention, l'élément de structure 1 comporte des moyens conducteurs 5 ou par dépôt métallique sous vide.

Les moyens conducteurs 5 sont réalisés par des fils métalliques entrecroisés, formant un grillage 5.

Le grillage 5 est apposé contre la couche de matériau diélectrique 3 de sorte à être en contact avec elle, et y est maintenu par une colle 7 dans laquelle il est noyé, la colle 7 constituant des moyens d'adhésion.

La colle 7 peut être celle habituellement utilisée pour le collage du polyimide que l'on trouve couramment sur les bandes adhésifs de kapton®.

Pour permettre d'évacuer les charges qui peuvent s'accumuler sur la couche de polymère de polyimide, un fil conducteur 9 est relié au grillage 5.

Le fil conducteur 9 pourrait être tout autre élément conducteur.

Le fil conducteur 9 constitue un moyen de liaison pour relier le grillage 5 à la masse de la structure.

La figure 3 illustre un autre mode de réalisation d'un élément de structure 11 pour panneau solaire.

L'élément 11 comporte deux couches de matériau diélectrique 3, réalisées chacune en polymère de polyimide.

Les deux couches 3 sont superposées et reliées ensemble par une couche de colle 7 dans laquelle est noyé un grillage 5, ladite couche de colle 7 étant emprisonné entre deux couches 3 de sorte que l'empilement de couches forme une structure dite « sandwich ».

De manière similaire au mode de réalisation présenté sur les figures 1 et 2, le grillage 5 est solidaire d'un fil métallique 9 formant un moyen de liaison pour relier le grillage 5 à la masse de la structure.

La figure 4 montre une structure 13 conforme à l'invention comportant l'élément 11 de structure illustré en figure 3.

Outre l'élément de structure 11, la structure 13 comporte un ensemble de base 15 comprenant une couche de matériau conducteur 17 emprisonnée entre deux couches de rigidification 19.

La couche de matériau conducteur 17 peut être une feuille d'aluminium 17 présentant une structure en nid d'abeille.

La feuille d'aluminium 17 est reliée à la masse de la structure.

Les couches de rigidification 19 sont chacune réalisée sous la forme d'une une couche comportant un maillage de fibres de carbone emprisonnées dans une couche de colle époxy.

Le grillage 5 de fils métalliques est relié à la feuille d'aluminium 17 à structure en nid d'abeille par le fil conducteur 9. Le grillage 5 pourrait être aussi relié au pôle moins (-) des cellules solaires.

La structure 13 comporte également des cellules photoélectriques 21.

Les cellules photoélectriques 21 sont disposées sur la couche de matériau diélectrique 3, de manière classique en soi, selon une configuration matricielle.

Seules deux cellules photoélectriques 21 ont été représentées sur la figure 4 pour en simplifier la lecture.

Les cellules photoélectriques 21 sont fixées sur la couche de matériau diélectrique 3 par une couche de colle 23 qui est de la colle silicone (la cellule est fragile, on utilisera de la colle silicone plutôt que de la colle époxy, qui elle sera davantage utilisée pour coller des structures rigides).

Chacune des cellules photoélectriques 21 est recouverte d'une plaque de verre protectrice 25, de dimensions sensiblement égales à celles des cellules 21.

Les plaques de verre de protection 25 sont maintenues sur les cellules photoélectriques par une couche de colle 27 qui peut être de la colle silicone.

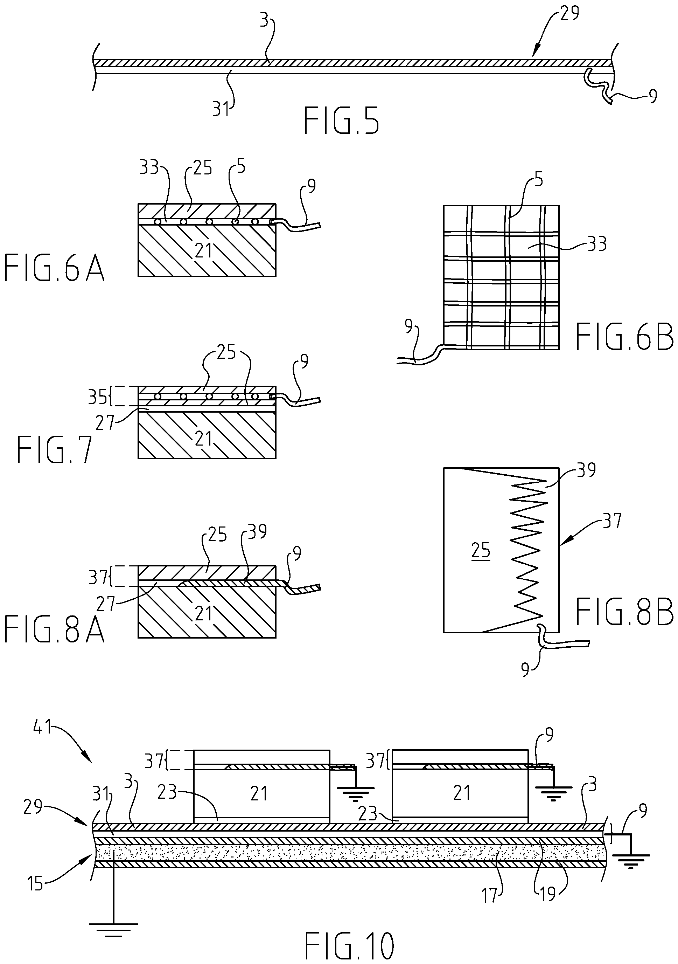

La figure 5 montre une autre variante de réalisation d'un élément de structure 29.

L'élément de structure 29 comporte une couche de matériau diélectrique 3 et une couche de matériau conducteur 31.

La couche de matériau conducteur 31 est, par exemple, un revêtement métallique déposé sur l'une des faces de la couche de matériau diélectrique 3, de façon en soi connu de l'homme du métier.

Dans le cadre de ce mode de réalisation, le revêtement métallique 31 est déposé sur toute la surface de l'une des faces de la couche de matériau diélectrique 3.

Un fil conducteur 9 est relié à la couche de matériau métallique 31, pour relier le revêtement métallique 31 à la masse de la structure.

Les figures 6A, 6B, 7, 8A et 8B représentent d'autres modes de réalisation d'éléments de structures conformes à l'invention suivant lesquels la plaque de verre protectrice 25 des cellules photoélectriques 21, qui constitue elle-même une couche de matériau diélectrique, est associée à des moyens d'évacuation des charges électriques.

La figure 6A illustre une plaque de verre protectrice 25 sur laquelle, côté cellule 21, est apposé et fixé un grillage de fils ou conducteurs métalliques 5 relié à un fil conducteur 9.

De préférence, le grillage 5 est déposé sous vide directement sur le verre. En variante, le grillage 5 peut être maintenu contre ou fixé à la plaque de verre 25 en étant noyé dans une couche de colle silicone 33.

La couche de colle silicone 33 sert également de moyen de fixation de la plaque de verre 25 sur une cellule photoélectrique 21.

La figure 7 montre encore une autre variante de réalisation d'un élément de structure de panneau solaire, selon lequel un élément 35 protecteur d'une cellule 21 comporte deux plaques de verre 25 reliées par l'une de leurs faces au moyen d'une couche de colle silicone 33 dans laquelle est noyée un grillage de fils conducteurs 5.

Un fil conducteur 9 est fixé sur le grillage 5 afin de connecter le grillage à la masse.

L'élément 35 est lui-même fixé sur la surface de la cellule photoélectrique 21 par une couche de colle silicone 27 répartie sur la surface libre de la plaque de verre adjacente à la cellule 21.

Les figures 8A et 8B montrent encore une variante de réalisation d'un élément de structure de panneau solaire conforme à l'invention.

L'élément protecteur 37 d'une cellule photoélectrique 21 comporte une plaque de verre protectrice 25.

Sur l'une des surfaces de la plaque de verre 25, un revêtement ou film métallique 39 a été déposé ponctuellement, c'est-à-dire sur une partie de la surface seulement.

Un fil conducteur 9 est relié au film métallique 39, de sorte à pouvoir relier l'élément de structure 37 à la masse de cette dernière.

L'élément 37 ainsi réalisé est fixé sur la cellule photoélectrique 21 par une couche de colle silicone 27.

Pour des raisons de rendement de la cellule photoélectrique 21, il convient de réaliser le film 39 de sorte qu'il cache le moins possible la cellule 21.

Dans un souci de lecture des figures, le film 39 a été représenté volontairement de façon grossière.

Il devra toutefois être entendu que le revêtement ou film doit être le moins envahissant possible pour altérer le moins possible les capacités de la cellule 21.

La figure 9 illustre une autre variante de réalisation dans laquelle le revêtement 39 est réalisé sous la forme d'un peigne métallique s'étendant sur un côté de la plaque de verre 25. Un peigne métallique identique 40 est réalisé sur la face supérieure en regard de la cellule 21, dont la face opposée présente une métallisation 42. Ainsi, en superposant les deux peignes, on ne masque pas la partie utile de la cellule. On peut également prévoir un contact direct avec un plot conducteur à travers la colle silicone.

La figure 10 montre une structure 41 conforme à l'invention, comportant des cellules photoélectrique 21, fixées par une couche de colle époxy 23 sur un élément de structure 29 tel qu'illustré en figure 5.

L'élément de structure 29 est fixé sur un ensemble de base 15 tel que défini précédemment, comprenant une superposition de trois couches de matériaux, et plus particulièrement une couche de matériau conducteur 17 emprisonnée entre deux couches de rigidification 19.

La couche de matériau conducteur 17 est reliée à la masse de la structure.

Les cellules photoélectriques 21 de la structure 41 sont chacune recouvertes d'un élément protecteur 37 tel qu'illustré en figures 8A et 8B.

Chaque revêtement 39 des éléments 37 est relié à la masse de la structure par un fil conducteur 9, de sorte que les charges se trouvant sur la plaque de verre sont évacuées par le fil 9.

On comprend de la description qui précède comment l'invention permet d'évacuer les charges qui s'accumulent sur une couche de composant diélectrique.

Il devra toutefois être entendu que l'invention n'est pas limitée à l'utilisation de certains matériaux tels que ceux présentés dans les exemples de réalisation qui ont été décrits, comme le polymère de polyimide ou bien les colles époxy ou silicone.

Par ailleurs, selon un autre mode de réalisation, les moyens conducteurs 5 ne forment pas un grillage, mais un serpentin ou une spirale, en contact avec la couche de matériau diélectrique 3, et solidaire d'un moyen de connexion électrique formant un moyen de liaison pour relier les moyens conducteurs à la masse de la structure.

## Revendications

1. Structure (13 ; 41) de panneau solaire comportant :
- Un élément de structure (11 ; 29) pour panneau solaire, comprenant au moins une couche de matériau diélectrique (3), des moyens conducteurs (5 ; 31) qui sont en contact avec ladite couche de matériau diélectrique (3) et un moyen de connexion électrique (9) pour relier les moyens conducteurs (5 ; 31) à la masse de ladite structure;
- Une pluralité de cellules photoélectriques (21) disposées sur la couche de matériau diélectrique (3);
**Caractérisée en ce qu'**elle comprend en outre un ensemble de base (15) comprenant une couche de matériau conducteur (17) emprisonnée entre deux couches de rigidification (19), l'élément de structure (11; 29) étant disposé sur l'ensemble de base (15), la couche de matériau conducteur (17) étant reliée à la masse de ladite structure, les moyens conducteurs (5 ; 31) étant en contact avec l'une des couches de rigidification (19), les moyens conducteurs (5 ; 31) étant formés par un grillage, un serpentin ou une spirale de conducteurs métalliques ou par un revêtement métallique déposé sur le matériau diélectrique (3).

2. Structure selon la revendication 1, **caractérisée en ce que** lesdits moyens conducteurs (5) comportent un grillage de fils ou conducteurs métalliques.

3. Structure selon la revendication 2, **caractérisée en ce que** ledit grillage métallique (5) est apposé contre une surface de ladite couche de matériau diélectrique (3), et maintenu par des moyens d'adhésion (7) ou déposé sous vide.

4. Structure selon la revendication 2, **caractérisée en ce que** ledit grillage (5) est disposé entre deux couches de matériau diélectrique (3).

5. Structure selon la revendication 1, **caractérisée en ce que** lesdits moyens conducteurs (31) comportent un revêtement conducteur (31) recouvrant au moins partiellement une surface de ladite couche de matériau diélectrique (3).

6. Structure selon l'une quelconque des revendications précédentes, **caractérisée en ce que** ladite couche de matériau diélectrique (3) est réalisée en polymère de polyimide.

7. Structure selon l'une quelconque des revendications précédentes, **caractérisée en ce que** ledit moyen de connexion électrique est un élément conducteur (9).

8. Panneau solaire comprenant une structure selon l'une quelconque des revendications précédentes.

## Patentansprüche

1. Solarpanel-Struktur (13; 41), Folgendes umfassend:
- ein Strukturelement (11; 29) für Solarpanels, umfassend wenigstens eine Schicht von dielektrischem Material (3), leitende Mittel (5; 31), die in Kontakt mit der Schicht von dielektrischem Material (3) sind, und ein elektrisches Verbindungsmittel (9) zum Legen der leitenden Mittel (5; 31) an die Masse der Struktur;
- eine Vielzahl von photoelektrischen Zellen (21), angeordnet auf der Schicht von dielektrischem Material (3);
**dadurch gekennzeichnet, dass** sie weiter ein Basisset (15) umfasst, umfassend eine Schicht von leitendem Material (17), eingeklemmt zwischen zwei Steifigkeitsschichten (19), wobei das Strukturelement (11; 29) auf dem Basisset (15) angeordnet ist, wobei die Schicht von leitendem Material (17) an die Masse der Struktur gelegt ist, wobei die leitenden Mittel (5; 31) in Kontakt mit einer der Steifigkeitsschichten (19) sind, wobei die leitenden Mittel (5; 31) durch ein Gitter, eine Spule oder eine Spirale von metallischen Leitern oder durch eine metallische Beschichtung, aufgebracht auf das dielektrische Material (3), gebildet werden.

2. Struktur nach Anspruch 1, **dadurch gekennzeichnet, dass** die leitenden Mittel (5) ein Gitter aus metallischen Drähten oder Leitern umfassen.

3. Struktur nach Anspruch 2, **dadurch gekennzeichnet, dass** das metallische Gitter (5) gegen eine Oberfläche der Schicht aus dielektrischem Material (3) angebracht ist, und von Haftmitteln (7) gehalten oder unter Vakuum aufgebracht ist.

4. Struktur nach Anspruch 2, **dadurch gekennzeichnet, dass** das Gitter (5) zwischen zwei Schichten von dielektrischem Material (3) angebracht ist.

5. Struktur nach Anspruch 1, **dadurch gekennzeichnet, dass** die leitenden Mittel (31) eine leitende Schicht (31) umfassen, wenigstens teilweise eine Oberfläche der Schicht aus dielektrischem Material (3) bedeckend.

6. Struktur nach einem der vorhergehenden Ansprüche, **dadurch gekennzeichnet, dass** die Schicht aus dielektrischem Material (3) aus Polymid-Polymer besteht.

7. Struktur nach einem der vorhergehenden Ansprüche, **dadurch gekennzeichnet, dass** das Mittel zur elektrischen Verbindung ein Leitelement (9) ist.

8. Solarpanel, umfassend eine Struktur nach einem der vorhergehenden Ansprüche.

## Claims

1. A solar panel structure (13; 41) including:
- A structural element (11; 29) for a solar panel, comprising at least one dielectric material layer (3), conductive means (5; 31) which are in contact with said dielectric material layer (3) and electrical connection means (9) for connecting the conductive means (5; 31) to the ground of said structure;
- A plurality of photoelectric cells (21) disposed on the dielectric material layer (3);
**Characterized in that** it further comprises a base assembly (15) comprising a conductive material layer (17) trapped between two stiffening layers (19), the structural element (11; 29) being disposed on the base assembly (15), the conductive material layer (17) being connected to the ground of said structure, the conductive means (5; 31) being in contact with one of the stiffening layers (19), the conductive means (5; 31) being formed by a grid, a coil or a spiral of metal conductors or by a metal coating deposited on the dielectric material (3).

2. The structure according to claim 1, **characterized in that** said conductive means (5) include a grid of metal wires or conductors.

3. The structure according to claim 2, **characterized in that** said metal grid (5) is affixed against a surface of said dielectric material layer (3), and held by adhesion means (7) or disposed under vacuum.

4. The structure according to claim 2, **characterized in that** said grid (5) is disposed between two dielectric material layers (3).

5. The structure according to claim 1, **characterized in that** said conductive means (31) include a conductive coating (31) at least partially covering a surface of said dielectric material layer (3).

6. The structure according to any one of the preceding claims, **characterized in that** said dielectric material layer (3) is made of polyimide polymer.

7. The structure according to any one of the preceding claims, **characterized in that** said electrical connection means is a conductive element (9).

8. A solar panel comprising a structure according to any one of the preceding claims.
